Europäisches Patentamt

European Patent Office

Office européen des brevets

(11) Publication number: **0 002 832**
**B1**

## (12) EUROPEAN PATENT SPECIFICATION

(45) Date of publication of patent specification: **21.08.85**

(51) Int. Cl.⁴: **C 23 C 14/34**

(21) Application number: **78101856.9**

(22) Date of filing: **27.12.78**

(54) **Method and apparatus for sputtering photoconductive coating on endless flexible belts or cylinders.**

(30) Priority: **27.12.77 US 864330**

(43) Date of publication of application:
**11.07.79 Bulletin 79/14**

(45) Publication of the grant of the patent:
**21.08.85 Bulletin 85/34**

(84) Designated Contracting States:
**DE FR GB NL SE**

(56) References cited:
**DE-A-1 912 917**
**DE-A-2 024 005**
**FR-A-2 239 713**
**GB-A- 424 504**
**US-A-1 974 441**
**US-A-3 905 887**

**IBM TECHNICAL DISCLOSURE BULLETIN, vol.
2, 1959, no. 2, F. DYMAN et al., "Vacuum
metallizing with controlled planar sources",
pages 32-33**

(73) Proprietor: **STORK BRABANT B.V.**
**43a Wim de Körverstraat**
**NL-5831 AN Boxmeer (NL)**

(72) Inventor: **Vertegaal, Jacobus Gerardus**
**Van Grotenhuisstraat 3**
**NL-5831 GL Boxmeer (NL)**
Inventor: **Anselrode, Lodewijk**
**Peelkant 52**
**NL-5845 EJ St. Anthonis (NL)**

(74) Representative: **Dorner, Jörg, Dr.-Ing. et al**
**Landwehrstrasse 37**
**D-8000 München 2 (DE)**

Courier Press, Leamington Spa, England.

## Description

The general field of the invention comprises a sputtering apparatus for sputtering a coating of photoconductive material onto a flexible substrate member.

In recent times a technique was developed for the sputtering of electrophotographic film which is a meter or more in width and several hundred meters long through the use of sputtering methods and apparatus disclosed in U.S. Patents 3 829 373, 3 884 787, 4 013 539, 4 026 787 and, particularly, 3 905 887.

The last mentioned US—Patent discloses a sputtering apparatus for sputtering a coating of a photoconductive material onto a flexible substrate member in a sputtering vessel having a sputtering chamber and, within said chamber, an anode arrangement, a target arrangement and a r.f. power supply, for establishing a sputtering condition in the chamber, said target arrangement consisting of photoconductive material and said anode arrangement being arranged opposite said target arrangement so that a plurality of gaps is formed between them, the plasma condition appearing within the gaps during the sputtering operation.

With the known apparatus the anode arrangement has the shape of a drum over which a tape like substrate can be lead from a supply reel to a take up reel for winding up the sputter coated substrate. A number of cylinder sector shaped targets are positioned around the circumference of the anode drum leaving a comparatively small sector of the anode circumference unoccupied by a target so that in this free area the substrate can enter into and leave from the anode-target-system.

The known apparatus does not allow to handle substrates in shape of a seamless belt or cylinder in such manner that the substrate can be easily positioned into the operatus for sputtering nor is it possible in the known apparatus to stretch out a seamless sleeve-shaped substrate for sputtering in such manner that a plurality of precisely dimensioned plasma regions could be lined up along the way of the substrate, in order to obtain a highly uniform sputtering coating.

It is known, furthermore, from German Offenlegungsschrift 2 024 005, to stretch between two drum shaped support members a substrate in shape of a seamless belt and to provide a number of vapor deposition units along one straight side of the substrate which, in the known apparatus, is part of the vapor deposition machine. The known apparatus does not serve for sputtering a photoconductor onto seamless belts or cylinders which could be easily put into the sputtering apparatus, sputter-coated and, thereafter, removed from the apparatus. Particularly, the known apparatus does not serve for generating a highly uniform coating on a substrate since, with the known system, the coating is scratched off the substrate after having been deposited.

It is an object of the present invention to provide a sputtering apparatus of the general construction known from US—Patent 3 905 887, however, being designed in such manner that seamless cylinders or belts can be sputter-coated with a highly uniform photoconductive coating whereby the substrates can be easily put into and removed from the apparatus and whereby the precisely dimensioned plasma regions would not be limited to only a part of the anode drum circumference.

This object, in accordance with the present invention, is achieved by at least two support members, being movable towards and away from each other and having arcuate sides facing away from one another, the substrate member having the shape of a seamless cylinder or belt, being capable of being stretched between said support members thereby forming the substrate member into an oval, said anode arrangement comprising anode means being provided as part of a first one of said support members and further anode means between said support members and said target arrangement comprising target means conforming to the arcuate side of said first support member and further target means forming gaps with said further anode means in the region of the straight sides of the substrate lead through said gaps, further characterized by tensioning means for biassing said first support member and a second support member of said support members to move apart for putting said substrate member under tension, and means for driving the substrate member over the support members to pass through said gaps.

In accordance with one embodiment the support members are arranged vertically one above the other. Preferently one of said support members has the shape of a rotary drum. Such rotary drum can be connected to a driving motor.

The support members can be bushed apart by spring means in order to stretch the seamless belt or cylinder forming the substrate.

The distance between the support member can be adjustable for different sizes of sleeve substrate members.

In those cases, in which the support members are arranged vertically one above the other, said tensioning means are provided in form of the weight of the bottom support member which is a guided roller of substantial weight and hanging down from the upper support member through the medium of the flexible sleeve substrate member during the sputtering operation. It is also possible to bias the support members away from each other magnetically, e.g. by means of magnets acting on a lower support drum of magnetic material.

The rotary drum mentioned before can comprise one anode of the anode arrangement.

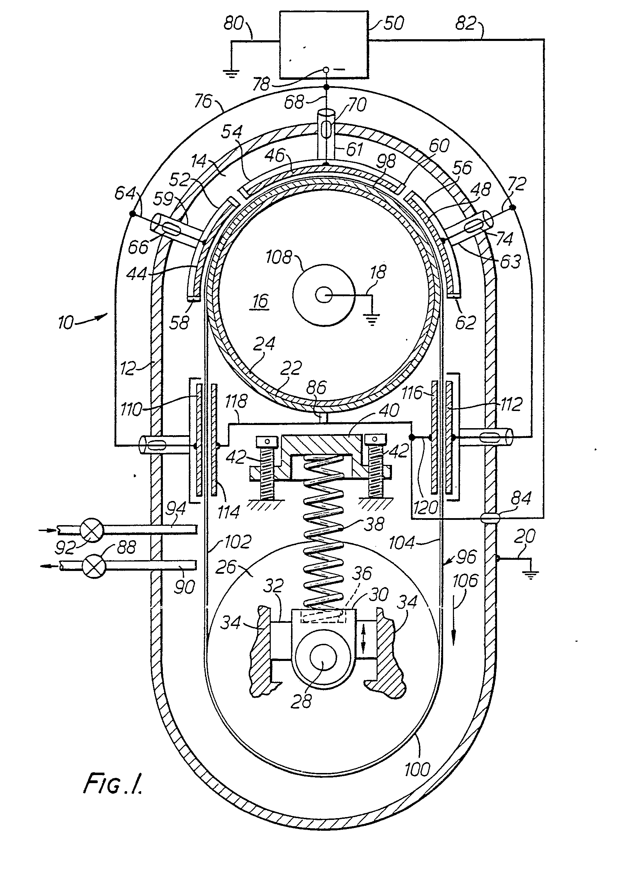

A preferred embodiment of the invention will now be described by way of example with reference to the drawing which shows a diagramatic sectional view through a sputtering apparatus constructed in accordance with the invention.

The sputtering apparatus of the invention is concerned especially with the sputter deposition of photoconductive material upon cylindrical or belt-shaped substrates useful in different kinds of imaging apparatus such as for office copiers, printing plate makers, printing presses and the like. Although adapted for the depositing of the material upon substrate members of plastic, the invention has desirable application to deposition of photoconductive material upon substrate members comprising sleeves of flexible metal, e.g. seamless thin-walled metal cylinders of nickel, copper or other material which is formed by electrodeposition. The sputtering apparatus of the present invention is especially intended for the use in sputtering a photoconductive coating of the type disclosed in said U.S. Patent 4,025,339 but is not necessarily limited thereto. The description herein will be specifically directed to the requirements for such sputtering as exemplary.

Although electrodeposition is used herein, the term "electroforming" is synonymous therewith.

In the drawing there is illustrated an apparatus 10 which is very diagrammatic. Considerable structure and operating systems are omitted but reference can be had to the patents mentioned above for supplying any further details which are required. U.S. Patents 3,976,555 and 4,014,779 respectively may be referred to for other structure concerning the introduction of background gas and the maintenance of the anode at a bias potential. No supporting framework or base for the apparatus is shown in the drawing but is presumed to be provided. Also closures, seals, coolant and heat exchange liquid systems, etc. are not shown.

The apparatus 10 comprises a pressure vessel 12 which in this case is arranged to have a relatively narrow transverse dimension and a relatively high vertical dimension as shown. This is feasible because of the construction to be described which enables the apparatus 10 to occupy less floor space than if it were constructed otherwise. The pressure vessel defines an interior chamber 14 within which the sputtering will take place. Mounted at the top of the chamber 14 is a support member in the form of a drum 16 which, in this case, is formed of metal and grounded at 18. For practical purposes the vessel 10 is of metal and grounded as well, as indicated at 20.

The drum 16 has an outer metal skin 22 which is insulatedly mounted relative to the body of the drum 16 by means of a coating or layer of insulating material 24 so that the skin is not at ground potential. This will shortly be explained.

At the bottom of the chamber 14 there is mounted a support member 26 which, in this case, is an idler drum mounted on a shaft 28 journalled in a pillow block 30 that in turn is mounted on a slide 32 that is confined for vertical up and down movement by the guides 34. These guides 34 are fixed to a suitable wall or framework (not shown) mounted to the vessel 12. A seat 36 holds the bottom end of a helical spring 38 whose upper end is engaged against a bracket 40 which can be raised or lowered by suitable jack screws 42 to change the tension of the spring 38 and thereby vary the effective distance between the drum 16 and the support 26.

There are three targets shown at 44, 46 and 48 arcuately arranged around the upper side of the drum 16 and spaced therefrom in parallel arrangement. This forms the gap between the targets and the anode in which the electric plasma for sputtering will appear. Each target has its own base, shielding and electrical connection to the r.f. supply 50. Each is mounted to the wall of the vessel 12. The bases are 52, 54 and 56, respectively; the shielding is shown at 58, 60 and 62, respectively and will be considered grounded; the connections are 64 through the insulating lead-in 66, 68 through the insulating lead-in 70, and 72 through the insulating lead-in 74; and the mountings are 59, 61 and 63. The coolant system connected with the bases 52, 54 and 56 is not shown. A harness 76 is illustrated coupled to all of the connections 64, 68 and 72 extending to the high negative potential terminal 78 of the r.f. power supply 50, but it is to be understood that this is only by way of symbol. There will have to be proper matching and tuning of targets to assure maximum transfer of power.

The r.f. power supply 50 is shown grounded at 80 and there is also a low voltage bias line 82 which comes through a suitable insulating lead-in 84 and connects to a wiper 86 that slides on the skin 22. Thus, part 22 is the effective anode and is at a voltage which is somewhat below ground considering the field conditions in the diode system of the sputtering apparatus. This provides the bias potential.

The chamber 14 is evacuated and maintained at low pressure by means of suitable vacuum pumps (not shown except by the arrows) connected through the valve 88 in the line 90. Background gas (also referred to by the arrow) is furnished by way of the valve 92 in the line 94.

In operation, a substrate member 96 which may be either a metal or plastic cylinder or a belt is strtched over the drums 16 and 26. This is easily done by adjusting the position of the bracket 40, which, as will be understood, is only an example of a structure for adjusting the distance between the two supports 16 and 26. After engaging the substrate member 96 in place, it is configured in the form of an oval, with arcuate ends 98 and 100 at the top and bottom respectively and parallel sides 102 and 104. It is seen that the width of the apparatus 10 would have to be substantially increased if a single drum were used as the mounting for the substrate member 96 and the latter were shaped into cylindrical form to be so mounted.

By lowering of the bracket 40 by means of the screws 42 the spring 38 is compressed and thereby tension of the parallel sides 102 and 104 of the substrate member 96 is applied. In this condition, the substrate member 96 is moved, as for example in the direction of the arrow 106. The shaft 108 of the drum 16 may be rotated in a suitable direction by means (not shown) external of the chamber 14 and coupled to the shaft 108 through the wall of the vessel 12. At the same time the systems are all set in operation to cause the sputtering and the movement is maintained for a time sufficient to build up the desired deposit of photoconductor.

Where the substrate member 96 is metal, the sputtering of the photoconductor is done directly. Where the substrate is of polyester or other insulating material, a layer of ohmic material such as indium-tin oxide is earlier deposited onto the surface of the substrate member 96 which ohmic layer facilitates charging of the surface of the produced photoconductor recording material during use.

Thereafter the photoconductor material is sputtered onto the ohmic layer.

The ohmic layer can be deposited using the same apparatus or different apparatus. Its thickness is usually several tens of nm while the thickness of the photoconductive layer is normally of the order of 200 nm to about 600 nm.

Additional targets and anodes are provided as shown symbolically in the center of the drawing. The targets 110 and 112 have construction similar to that of the other targets and are mounted in the same way, connected to the power harness 76 in the same way; hence no further description of the same is needed. Each has an anode 114 and 116 whose mountings are not shown but whose connections to the bias potential line 82 are shown at 118 and 120.

## Claims

1. Sputtering apparatus for sputtering a coating of a photoconductive material onto a flexible substrate member (96) in a sputtering vessel having a sputtering chamber (14) and, within said chamber, an anode arrangement (22, 114, 116), a target arrangement (44, 46, 48, 110, 112) and r.f. power supply (50), for establishing a sputtering condition in the chamber, said target arrangement consisting of photoconductive material and said anode arrangement being arranged opposite said target arrangement so that a plurality of gaps is formed between them, the plasma condition appearing within the gaps during the sputtering operation, characterized by at least two support members (16, 26), being movable towards and away from each other and having arcuate sides facing away from one another, the substrate member (96), having the shape of a seamless cylinder or belt, being capable of being stretched between said support members thereby forming the substrate member into an oval, said anode arrangement (22, 114, 116) comprising anode means (22) being provided as part of a first one (16) of said support members (16, 26) and further anode means (114, 116) between said support members, and said target arrangement (44, 46, 48, 110, 112) comprising target means (44, 46, 48) conforming to the arcuate side of said first support member and further target means (110, 112) forming gaps with said further anode means in the region of the straight sides of the substrate lead through said gaps further characterized by tensioning means (32, 34, 38, 40, 42) for biassing said first support member and a second support member of said support members (16, 26) to move apart for putting said substrate member under tension, and means (132) for driving the substrate member (96) over the support members (16, 26) to pass through said gaps.

2. The sputtering apparatus as claimed in claim 1 characterized in that the support members (16, 26) are arranged vertically one above the other.

3. The sputtering apparatus as claimed in claim 1 characterized in that one (16) of said support members (16, 26) is a rotary drum.

4. The sputtering apparatus as claimed in claim 3, characterized in that said rotary drum is connected to a driving motor (132).

5. The sputtering apparatus as claimed in claim 1, characterized in that said support members (16, 26) are pushed apart by spring means (38).

6. The sputtering apparatus as claimed in claim 1 to 5, characterized in that the distance between the support members (16, 26) is adjustable for different sizes of sleeve substrate members.

7. The sputtering apparatus as claimed in claim 2, characterized in that said tensioning means are provided in form of the weight of the bottom support member (26) which is a guided roller of substantial weight and hanging down from the upper support member (16) through the medium of the flexible sleeve substrate member (96) during the sputtering operation.

8. The sputtering apparatus as claimed in any one of claims 1 to 7, characterized in that said support members are biassed away from each other magnetically.

9. The sputtering apparatus as claimed in claim 4, characterized in that said rotary drum (16) also comprises one anode means (22).

## Patentansprüche

1. Sputtereinrichtung zum Aufsputtern eines Belages eines fotoleitfähigen Materials auf ein flexibles Trägerelement (96) innerhalb eines Sputtergefäßes mit einer Sputterkammer (14) und, innerhalb der Kammer, einer Anodenanordnung (22, 114, 116), einer Kathodenanordnung (44, 46, 48, 110, 112) sowie einer Hochfrequenzenergiequelle (50), um innerhalb der Sputterkammer eine Sputterbedingung zu erzeugen, wobei die Kathodenanordnung aus fotoleitfähigem Material besteht und die Anodenanordnung der Kathodenanordnung gegenüberliegend angeordnet ist, so daß eine Mehzahl von Spalträumen zwischen der Anodenanordnung und der Kathodenanordnung gebildet ist, und die Sputterplasmabedingung sich während des Sputterns in diesen Spalträumen ausbildet, gekennzeichnet durch mindestens zwei Trägereinrichtungen (16, 26), welche aufeinander zu und von einander weg bewegbar sind und bogenförmig gekrümmte, von einander weg weisende Seitenflächen aufweisen, wobei das Trägerelement (96), welches die Gestalt eines nahtlosen Zylinders oder einer nahtlosen Manschette hat, zwischen den Trägereinrichtungen spannbar ist, so daß es in ovale Form gebracht wird und wobei die Anodenanordnung (22, 114, 116) eine Anode (22) enthält, die als Teils einer ersten (16) der Trägereinrichtungen (16, 26) und weitere Anoden (114, 116) zwischen den genannten Trägereinrichtungen enthält, während die Kathodenanordnung (44, 46, 48, 110, 112) Kathodenmittel (44, 46, 48) enthält, die der bogenförmig gekrümmten Seitenfläche der genannten ersten Trägereinrichtung angepaßt sind, und weitere Kathodenmittel (110, 112) aufweist, welche Spalträume mit den genannten weiteren Anoden in dem Bereich der ausgespannten Seitenabschnitte des Trägerelementes ausbilden, welches durch diese Spalträume hindurch geführt ist, und weiter gekennzeichnet durch Spannmittel (32, 34, 38, 40, 42) zum Auseinanderspannen der genannten ersten Halteeinrichtung und einer zweiten Halteeinrichtung der erwähnten Halteeinrichtungen (16, 26), um das Trägerelement auszuspannen, sowie schließlich durch Mittel (132) zum Antrieb des Trägerelementes (96) zur Bewegung desselben über die Trägereinrichtungen (16, 26) derart, daß sich das Trägerelement durch die genannten Spalträume hindurchbewegt.

2. Sputtereinrichtung nach Anspruch 1, dadurch gekennzeichnet, daß die Trägereinrichtungen (16, 26) vertikal übereinander angeordnet sind.

3. Sputtereinrichtung nach Anspruch 1, dadurch gekennzeichnet, daß eine (16) der genannten Trägereinrichtungen (16, 26) die Gestalt einer Drehtrommel hat.

4. Sputtereinrichtung nach Anspruch 3, dadurch gekennzeichnet, daß die genannte Drehtrommel mit einem Antriebsmotor (132) verbunden ist.

5. Sputtereinrichtung nach Anspruch 1, dadurch gekennzeichnet, daß die Trägereinrichtungen (16, 26) durch Federmittel (38) auseinander gedrückt werden.

6. Sputtereinrichtung nach Anspruch 1 bis 5, dadurch gekennzeichnet, daß der Anstand zwischen den Trägereinrichtungen (16, 26) für unterschiedliche Größen des manschettenförmigen Trägerelementes einstellbar ist.

7. Sputtereinrichtung nach Anspruch 2, dadurch gekennzeichnet, daß die genannten Spannmittel durch das Gewicht der unteren Trägereinrichtung (26) gebildet werden, welche eine geführte Rolle beträchtlichen Gewichtes ist und von der oberen Trägereinrichtung (16) während des Sputterns an dem Trägerelement (96), welches die Gestalt einer flexiblen Manschette hat, herunterhängt.

8. Sputtereinrichtung nach einem der Ansprüche 1 bis 7, dadurch gekennzeichnet, daß die genannten Trägereinrichtungen magnetisch auseinandergespannt werden.

9. Sputtereinrichtung nach Anspruch 4, dadurch gekennzeichnet, daß die genannte Drehtrommel (16) auch eine Anode (22) umfaßt.

**Revendications**

1. Appareil de pulvérisation pour le dépôt par pulvérisation cathodique d'une matière photoconductrice sur un support flexible (96) dans une enceinte de pulvérisation comprenant une chambre de pulvérisation (14) et, à l'intérieur de cette chambre, un arrangement anodique (22, 114, 116), un arrangement formant la cible (44, 46, 48, 110, 112) et une source d'énergie à haute fréquence (50) pour établir les conditions de pulvérisation cathodique dans cette chambre, l'arrangement formant la cible étant constitué de matière photoconductrice et l'arrangement anodique étant disposé en face de l'arrangement formant la cible de manière à définir une série d'espaces entre ces arrangements dans lesquels les conditions de formation d'un plasma apparaissent lors de l'opération de pulvérisation, caractérisé par au moins deux éléments de support (16, 26) qui peuvent être rapprochés et éloignés l'un de l'autre et qui comportent respectivement des faces courbes opposées l'une à l'autre, la couche de support (96) ayant la forme d'un cylindre ou d'une bande sans soudure capable d'être tendue entre lesdits éléments de support et prendre ainsi la forme d'un oval, ledit arrangement anodique (22, 114, 116) comprenant des moyens anodiques (22) conçus comme partie d'un premier (16) desdits éléments de support (16, 26) et d'autres moyens anodiques (114, 116) entre lesdits éléments de support, et l'arrangement formant la cible (44, 46, 48, 110, 112) comprenant des moyens de cible (44, 46, 48) épousant la face courbe dudit premier élément de support et d'autres moyens de cible (110, 112) formant des espaces avec lesdits autres moyens anodiques dans la région des sections droites de la couche de support dirigée à travers lesdits espaces, caractérisé en outre par des moyens tendeurs (32, 34, 38, 40, 42) pour tendre ledit premier élément de support et un second élément de support desdits éléments de support (16, 22) l'un par rapport à l'autre afin de mettre la couche de support sous tension et des moyens (132) pour entraîner la couche de support (96) autour desdits éléments de support (16, 26) pour traverser lesdits espaces.

2. Appareil de pulvérisation selon la revendication 1, caractérisé en ce que les éléments de support (16, 26) sont disposés verticalement l'un au-dessus de l'autre.

3. Appareil de pulvérisation selon la revendication 1, caractérise en ce que l'un (16) desdits éléments du support (16, 26) est un tambour rotatif.

4. Appareil de pulvérisation selon la revendication 3, caractérisé en ce que ledit tambour rotatif est relié à un moteur d'entraînement (132).

5. Appareil de pulvérisation selon la revendication 1, caractérisé en ce que lesdits éléments de support (16, 26) sont écartés l'un de l'autre par des moyens élastiques (38).

6. Appareil de pulvérisation selon les revendications 1 à 5, caractérisé en ce que la distance entre les éléments de support (16, 26) est ajustable pour permettre l'introduction de couches de support de longueurs différentes.

7. Appareil de pulvérisation selon la revendication 2, caractérisé en ce que les moyens tendeurs sont constitués par le poids de l'élément de support inférieur (26) qui est un rouleau de guidage d'un poids substantiel et qui pend à l'élément de support supérieur (16) au moyen de la boucle flexible de la couche de support (96) pendant l'opération de pulvérisation cathodique.

8. Appareil de pulvérisation selon l'une quelconque des revendications 1 à 7, caractérisé en ce que la tension des éléments de support en sens opposé est provoquée par voie magnétique.

9. Appareil de pulvérisation selon la revendication 4, caractérisé en ce que le tambour rotatif (16) comporte un moyen anodique (22).

FIG. I.